# EUROPEAN PATENT APPLICATION

(11) **EP 2 725 587 A1**
(43) Date of publication of application: **30.04.2014**
(21) Application number: 12802253.0
(22) Date of filing: 22.06.2012
(51) Int. Cl.: H01B 13/00, G09F 9/30, H01L 21/28, H01L 21/314, H01L 21/3205, H01L 21/768, H01L 23/532

(54) **METHOD FOR FORMING CONDUCTIVE FILM, CONDUCTIVE FILM, INSULATION METHOD, AND INSULATION FILM**

(30) Priority: 24.06.2011 JP 2011141205
(71) Applicant: Kuraray Co., Ltd., Kurashiki-shi, Okayama 710-0801 (JP)
(72) Inventor: TANABE Hirofumi, Tsukuba-shi Ibaraki 305-0841 (JP); OTAKE Tomiaki, Tsukuba-shi Ibaraki 305-0841 (JP); MATSUGI Hiroshi, Tsukuba-shi Ibaraki 305-0841 (JP)
(74) Representative: Müller-Boré & Partner Patentanwälte PartG mbB
(86) International application number: PCT/JP2012/066069
(87) International publication number: WO 2012/176905

(57) **Abstract**

The object of the present invention is to provide a high-resolution conductive pattern. A conductive film formation method for forming a conductive film in a prescribed pattern comprises: a step in which a conductive carbon nanotube layer is formed; and an ultraviolet ray irradiation step in which areas of the conductive carbon nanotube layer formed in the above step, other than parts corresponding to the prescribed pattern, are irradiated with ultraviolet rays. Conductive carbon nanotubes in the ultraviolet ray irradiation areas turn insulating. Conductive carbon nanotubes in ultraviolet ray non-irradiation areas retain their conductive property.

## Description

### [TECHNICAL FIELD]

The present invention relates to a transparent conductive film that is usable for transparent electrodes of display panels (liquid crystal displays, plasma displays, organic EL displays, etc.), touch panels, and optoelectronic devices (e.g., solar cells).

### [BACKGROUND ART]

There has been known a transparent conductive film substrate which is produced by forming a transparent conductive film made of indium tin oxide (ITO) or the like on a transparent substrate. Substrates of this type are used for, for example, display panels (liquid crystal displays, plasma displays, organic EL displays, etc.), touch panels, and solar cells. Such substrates are also used in various other fields. Incidentally, the transparent conductive film is formed in a prescribed pattern. Chemical etching means (photolithography means using a photoresist and an etching solution) is generally employed as a method for forming the pattern.

However, the chemical etching technique requires a lot of steps like the following procedure: a photoresist film formation step (applying a photoresist coating material on an ITO film deposited on the entire surface of the substrate) → a photoresist film patterning step (forming the photoresist film into a prescribed pattern by exposure and development) → an ITO film etching step (etching the ITO film by using the photoresist film in the prescribed pattern as a mask) → a photoresist film removal step. Further, the chemical etching technique involves problems such as deterioration in the precision of the etching (due to the swelling of the photoresist film in the solution), difficulty in the handling of the etching solution, and processing of the waste liquid.

As a method for resolving such problems, there has been proposed a laser ablation method, in which unnecessary parts are removed by directly irradiating the conductive film with a laser beam. This method, needing no photoresist, enables high-precision patterning.

In this method, however, employable base materials are restricted. Further, the process cost is high and the processing speed is low. Therefore, this method is not suitable for mass production processes.

As chemical etching techniques not needing the photolithography step, there have been proposed (JP-P2008-547232A) "the use of iron chloride (III) or iron chloride (III) hexahydrate as an etching component in a composition for oxide surface etching", "the use of iron chloride (III) or iron chloride (III) hexahydrate as an etching component in a pasty composition used for manufacturing/constructing OLED illuminators, OLED displays, photodiodes, ITO glass for flat-panel screens (plasma displays), etc. in the fields of display technology (TFT), photovoltaic power generation, semiconductor technology, high-performance electronics, mineralogy and glass industry", and "a pasty and printable composition to be used for the etching of an oxide layer, comprising a) iron chloride (III) or iron chloride (III) hexahydrate as an etching component, b) a solvent, c) optionally, an organic thickening agent dissolved homogeneously, d) optionally, at least a type of inorganic acid and/or organic acid, and e) optionally, an additive such as an antifoaming agent, a thixotropic agent, a flow control agent, a degasser or an adhesion promoter".

There have also been proposed (JP-P2009-503825A) "an etching medium for etching a transparent conductive layer of an oxide, containing at least a type of etchant made of phosphoric acid, phosphate, phosphoric acid adduct, or a mixture of phosphoric acid and phosphate and/or phosphoric acid adduct" and "a method for etching a transparent conductive layer of an oxide wherein the aforementioned etching medium is employed for the substrate which is etched in a printing step".

In the techniques of JP-P2008-547232A and JP-P2009-503825A, however, the etching hardly proceeds uniformly on the entire surface and that leads to unevenness.

Besides transparent conductive films made of ITO, transparent conductive films made of carbon nanotubes are also well known. A carbon nanotube is a tube-shaped material having a diameter within 1 µm. A type of carbon nanotube in which the hexagonal carbon mesh faces are arranged in parallel with the tube axis to form the tube is the ideal material. There are also cases where the tube is formed in multiple-layer structure (multiple-wall structure). The carbon nanotube can exhibit metallic properties or semiconductive properties depending on the way of the linkage of the hexagonal carbon meshes and the thickness of the tube. Thus, carbon nanotubes are highly expected as functional materials. However, the thickness and the orientation can be random depending on the configuration and the manufacturing method of the carbon nanotubes. Therefore, for the use of the carbon nanotubes, it is sometimes necessary to collect and refine the carbon nanotubes after the synthesis and to carry out certain processing suitable for the form of the use. The following techniques have been proposed (JP-P2006-513557A, JP-P2007-529884A (WO 2005/086982 pamphlet)) for the patterning of this type of carbon nanotubes: For example, a carbon nanotube coating is formed by applying a carbon nanotube dispersion liquid on the surface of the substrate. A binder solution is applied on the carbon nanotube coating in a prescribed pattern. Thereafter, the solvent is dried. Accordingly, the binder is left in the carbon nanotube coating and the network of the carbon nanotubes is reinforced. Thereafter, the substrate is washed with a solvent that does not dissolve the binder. By this process, a pattern, in which only the parts where the binder exists (where the binder was applied) remain, is formed. It is also possible to use a photoresist material instead of the binder. Specifically, a coating material containing a photoresist is applied on the carbon nanotube coating, by which the carbon nanotube network is impregnated with the photoresist. Thereafter, the carbon nanotube coating is formed into a prescribed pattern by means of photolithography. It is also possible to directly form an already-patterned carbon nanotube coating on the substrate by use of an application method such as screen printing, inkjet printing or gravure printing.

However, the process is complicated in the technique carrying out the patterning after forming the carbon nanotube coating on the entire surface of the substrate. Meanwhile, in the case where an already-patterned carbon nanotube coating is directly formed on the substrate by use of an application method such as screen printing, the properties of the coating material containing carbon nanotubes have to be previously adjusted to those suitable for the application method. The adjustment of the carbon nanotube dispersion liquid is generally made by using a dispersant such as a surface active agent. In addition, viscosity of the carbon nanotube dispersion liquid is relatively low. Nevertheless, to achieve the ink properties suitable for the application method, the carbon nanotube dispersion liquid needs materials for adjusting its viscosity and surface tension. However, the mixing of other materials (solvent, metallic fine particles, binder, etc.) can deteriorate the dispersibility of the carbon nanotubes.

As substitutes for the techniques proposed by JP-P2006-513557A and JP-P2007-529884A, the following techniques have been proposed (WO 2010/113744 pamphlet): Specifically, there has been proposed a conductive film removing agent that contains a leveling agent and an acid whose boiling point is 80 °C or higher (e.g., sulfuric acid or sulfonic acid compound), a base whose boiling point is 80 °C or higher, or a compound, solvent or resin from which an acid or a base is generated by external energy (e.g., cationic resin containing any one of primary - quaternary amino groups as part of its structure). There has also been proposed a conductive film removing method that comprises a step of applying the above conductive film removing agent on at least part of a base material having a conductive film (containing a whisker-like conductor, a fiber-like conductor (e.g., carbon nanotubes) or a particulate conductor) thereon, a step of heating the structure at 80 °C or higher, and a step of removing the conductive film by washing the structure by use of a liquid. There has also been proposed such a conductive film removing method for removing an overcoat layer and the conductive film from the base material having the conductive film (having the overcoat layer on the conductive film). It is stated in the Patent Literature that a heating process performed at 80 - 200 °C after the application of the conductive film removing agent decomposes, dissolves or solubilizes parts of the conductive film (or parts of the overcoat layer and the conductive film in the case where the conductive film has the overcoat layer thereon) on which the conductive film removing agent was applied.

### [CITATION LIST]

### [PATENT LITERATURE]

Patent Literature 1: JP-P2008-547232A
Patent Literature 2: JP-P2009-503825A
Patent Literature 3: JP-P2006-513557A
Patent Literature 4: JP-P2007-529884A (WO 2005/086982 pamphlet)
Patent Literature 5: WO 2010/113744 pamphlet

### [SUMMARY OF INVENTION]

### [TECHNICAL PROBLEM]

However, the resolution of the pattern formed by the technique of the Patent Literature 5 employing the conductive film removing agent is low. For example, the resolution of the obtained pattern is equivalent to the resolution of the conductive film removing agent printing process (in general, the resolution by screen printing is approximately 30 µm).

Further, in the pattern formed by the technique of the Patent Literature 5, the optical transmittance differs between the parts from which carbon nanotubes have been removed and the parts where carbon nanotubes remain, due to the presence/absence of the material. Even if the conductive film is a transparent conductive film, various problems are expected since the optical transmittance varies depending on the position.

Furthermore, even if the overcoat layer is formed on top of the carbon nanotube layer, the removal of the carbon nanotube layer and the overcoat layer by use of the conductive film removing agent results in exposure of carbon nanotubes on the lateral surfaces (vertical wall surfaces). In other words, there exist carbon nanotube surfaces not covered by the overcoat layer. Problems are expected also from this viewpoint.

Moreover, a problem like formation of irregularities (convexities/concavities) on the surface can also be expected.

In addition, the technique of the Patent Literature 5 essentially requires a heating process of heating the conductive film removing agent applied in a prescribed pattern up to 80 °C or higher. Thus, the workability is low. Further, the substrate is required to have heat resistance over 80 °C. This lowers the degree of freedom of substrate selection.

The present invention has been made to resolve the above problems. In particular, the primary object of the present invention is to provide a conductive pattern having high resolution.

### [SOLUTION TO PROBLEM]

Investigations on the above problems were pursued energetically. In consequence, even though by chance, the present inventors found out that single-wall carbon nanotubes that underwent ultraviolet ray irradiation denatured from conductive into insulating.

Thereafter, the present inventors got to have an inspiration that it would be possible to employ this phenomenon for the formation of a conductive film in a prescribed pattern.

Further, the present inventors came to hold the conviction that the problem regarding the resolution of the conductive film pattern would be resolved drastically by employing this technique. Furthermore, the present inventors came to consider that the problems deriving from the removal of carbon nanotubes would also be resolved since the conductive pattern formation by means of ultraviolet ray irradiation does not remove carbon nanotubes.

The present invention was achieved based on such findings.

Namely, the aforementioned problems are resolved by a conductive film formation method for forming a conductive film in a prescribed pattern, comprising: a step in which a conductive carbon nanotube layer is formed; and an ultraviolet ray irradiation step in which areas of the conductive carbon nanotube layer formed in the above step, other than parts corresponding to the prescribed pattern, are irradiated with ultraviolet rays, wherein: conductive carbon nanotubes in the ultraviolet ray irradiation areas turn insulating, and conductive carbon nanotubes in ultraviolet ray non-irradiation areas retain their conductive property.

The aforementioned problems are resolved by a conductive film formation method for forming a conductive film in a prescribed pattern, comprising: a step in which a conductive carbon nanotube layer is formed; and an ultraviolet ray irradiation step in which areas of the conductive carbon nanotube layer formed in the above step, other than parts corresponding to the prescribed pattern, are irradiated with ultraviolet rays, wherein: ultraviolet ray non-irradiation areas are areas that should secure the conductive property in the prescribed pattern, while the ultraviolet ray irradiation areas are areas that should lose the conductive property in the prescribed pattern.

Preferably, the above conductive film formation method for forming a conductive film in a prescribed pattern further comprises a step in which an overcoat layer is formed on the surface of the conductive carbon nanotube layer.

Preferably, in the above conductive film formation method for forming a conductive film in a prescribed pattern, the conductive carbon nanotubes are single-wall carbon nanotubes that have undergone acid treatment.

Preferably, in the above conductive film formation method for forming a conductive film in a prescribed pattern, the ultraviolet ray irradiation step is a step in which the ultraviolet ray irradiation is performed via a mask having a function of blocking the ultraviolet rays in the parts corresponding to the prescribed pattern.

Preferably, in the above conductive film formation method for forming a conductive film in a prescribed pattern, the ultraviolet ray irradiation step is a step in which ultraviolet rays whose wavelength is in a range of 10 - 400 nm are used for the irradiation.

Preferably, in the above conductive film formation method for forming a conductive film in a prescribed pattern, the ultraviolet ray irradiation step is a step in which ultraviolet rays whose wavelength is in a range of 150 - 260 nm are used for the irradiation.

Preferably, in the above conductive film formation method for forming a conductive film in a prescribed pattern, the ultraviolet ray irradiation step is a step in which ultraviolet rays whose wavelength is in a range of 150 - 180 nm are used for the irradiation.

The aforementioned problems are resolved by a conductive film which is formed by the above conductive film formation method for forming a conductive film in a prescribed pattern.

The aforementioned problems are resolved by a conductive carbon nanotube insulation method for denaturing conductive carbon nanotubes into insulating carbon nanotubes, comprising an ultraviolet ray irradiation step in which the conductive carbon nanotubes are irradiated with ultraviolet rays.

The aforementioned problems are resolved by a conductive carbon nanotube insulation method for denaturing conductive carbon nanotubes into insulating carbon nanotubes, comprising an ultraviolet ray irradiation step in which the conductive carbon nanotubes in a part that should be insulated are irradiated with ultraviolet rays.

Preferably, in the above conductive carbon nanotube insulation method, the ultraviolet ray irradiation step is a step in which ultraviolet rays whose wavelength is in a range of 10 - 400 nm are used for the irradiation.

Preferably, in the above conductive carbon nanotube insulation method, the ultraviolet ray irradiation step is a step in which ultraviolet rays whose wavelength is in a range of 150 - 260 nm are used for the irradiation.

Preferably, in the above conductive carbon nanotube insulation method, the ultraviolet ray irradiation step is a step in which ultraviolet rays whose wavelength is in a range of 150 - 180 nm are used for the irradiation.

The aforementioned problems are resolved by an insulation film which is formed by the above conductive carbon nanotube insulation method.

### [ADVANTAGEOUS EFFECT OF INVENTION]

According to the present invention, a film having a high-resolution conductive (or insulating) pattern is obtained with ease.

Further, in the present invention, various problems deriving from the removal of carbon nanotubes are resolved quite differently from conventional techniques such as the conductive (or insulating) pattern formation through the removal of carbon nanotubes.

### [BRIEF DESCRIPTION OF DRAWINGS]

Fig. 1 is a schematic diagram showing a conductive carbon nanotube layer formation step in a conductive film formation step.
Fig. 2 is a schematic diagram showing an overcoat layer formation step in the conductive film formation step.
Fig. 3 is a schematic diagram showing an ultraviolet ray irradiation step in the conductive film formation step.
Fig. 4 is a schematic cross-sectional view showing layered structure after the ultraviolet ray irradiation.
Fig. 5 is a plan view of a pattern after the ultraviolet ray irradiation.

### [DESCRIPTION OF EMBODIMENTS]

The first invention is a pattern formation method. For example, the pattern formation method includes a method for forming a conductive film in a prescribed pattern. The pattern formation method also includes a method for forming a transparent conductive film in a prescribed pattern. In particular, the pattern formation method includes a method for forming a conductive film (transparent conductive film) made of a carbon nanotube layer in a prescribed pattern. Further, the pattern formation method includes a method for forming a composite layer having a carbon nanotube layer and an overcoat layer into a prescribed conductive pattern. This method comprises a step in which a conductive carbon nanotube layer is formed. For example, a coating material containing carbon nanotubes (e.g., dispersed therein) is applied on the substrate. By the application, the conductive carbon nanotube layer is formed. This method comprises an irradiation step in which the conductive carbon nanotube layer formed in the above step is irradiated with ultraviolet rays. In the irradiation step, areas other than the parts corresponding to the aforementioned prescribed pattern (conductive parts: e.g., wiring film parts) are irradiated with the ultraviolet rays. In other words, parts that should be made insulating are irradiated with the ultraviolet rays. The ultraviolet ray non-irradiation areas are areas that should secure the conductive property in the prescribed pattern, while the ultraviolet ray irradiation areas are areas that should lose the conductive property in the prescribed pattern. In short, the ultraviolet ray irradiation is performed on the carbon nanotubes in order to form the conductive pattern. To put it the other way round, the ultraviolet ray irradiation is performed on the carbon nanotubes in order to form an insulating pattern. Consequently, a conductive film in the prescribed pattern, in which conductive carbon nanotubes in the ultraviolet ray irradiation areas have turned insulating and conductive carbon nanotubes in the ultraviolet ray non-irradiation areas retain their conductive property, is formed. The ultraviolet ray non-irradiation areas are areas that should secure the conductive property in the prescribed pattern, while the ultraviolet ray irradiation areas are areas that should lose the conductive property in the prescribed pattern. The conductive carbon nanotubes are preferably single-wall carbon nanotubes, and particularly preferably, single-wall carbon nanotubes that have undergone acid treatment. Preferably, the carbon nanotubes are those satisfying a condition: G (intensity at a Raman peak appearing around 1590 cm⁻¹ and being common to graphite materials) / D (intensity at a Raman peak appearing around 1350 cm⁻¹ due to a defect) ≥ 10. The upper limit of the ratio G/D is approximately 150, for example. The ultraviolet ray irradiation is performed via a mask having a function of blocking the ultraviolet rays in the parts corresponding to the prescribed pattern, for example. The wavelength of the ultraviolet rays used for the irradiation is preferably 10 - 400 nm (more preferably 150 - 260 nm (still more preferably 150 - 180 nm)).

The second invention is a conductive film (and/or an insulation film) formed by the above method for forming a conductive film in a prescribed pattern.

The third invention is an insulation method (in particular, an insulation method for denaturing conductive carbon nanotubes into insulating carbon nanotubes). This method comprises an ultraviolet ray irradiation step in which conductive carbon nanotubes are irradiated with ultraviolet rays. In particular, this method comprises an ultraviolet ray irradiation step in which conductive carbon nanotubes in a part that should be insulated are irradiated with ultraviolet rays. The conductive carbon nanotubes are preferably single-wall carbon nanotubes, and particularly preferably, single-wall carbon nanotubes that have undergone acid treatment. Preferably, the carbon nanotubes are those satisfying the condition: G (intensity at the Raman peak appearing around 1590 cm⁻¹ and being common to graphite materials) / D (intensity at the Raman peak appearing around 1350 cm⁻¹ due to a defect) ≥ 10. The upper limit of the ratio G/D is approximately 150, for example. The ultraviolet ray irradiation is performed via a mask having the function of blocking the ultraviolet rays in the parts corresponding to the prescribed pattern, for example. The wavelength of the ultraviolet rays used for the irradiation is preferably 10 - 400 nm (more preferably 150 - 260 nm (still more preferably 150 - 180 nm)).

The fourth invention is an insulation film (and/or a conductive film) which is formed by the above conductive carbon nanotube insulation method.

More detailed explanation will be given below.

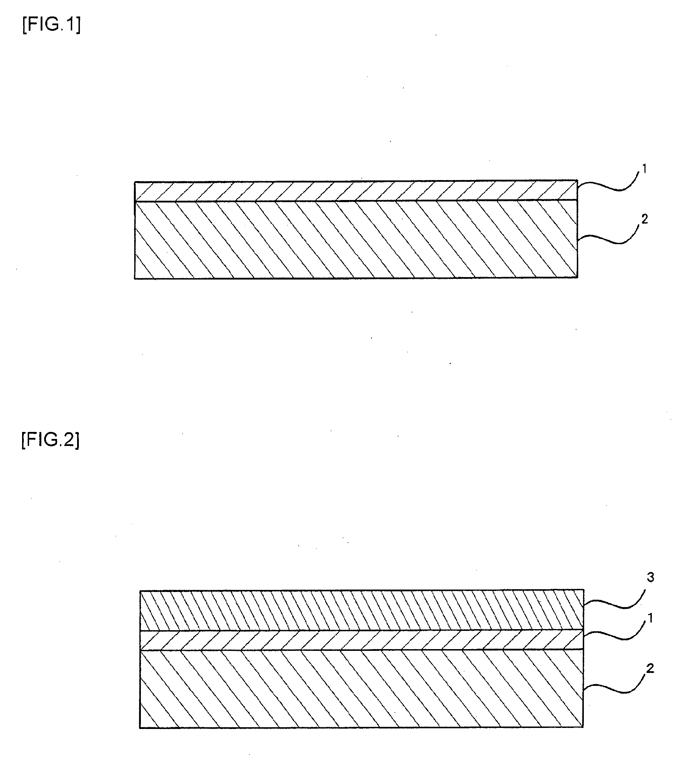

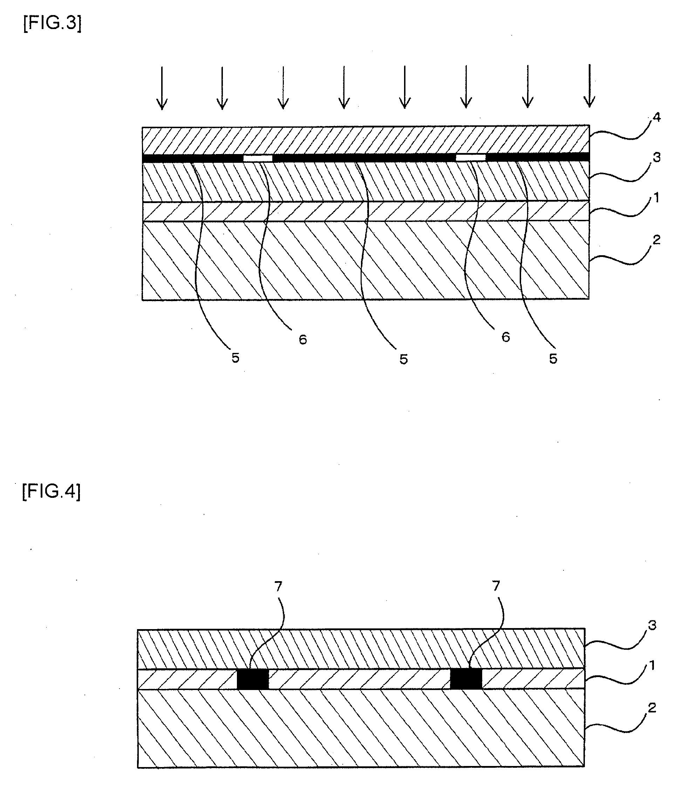

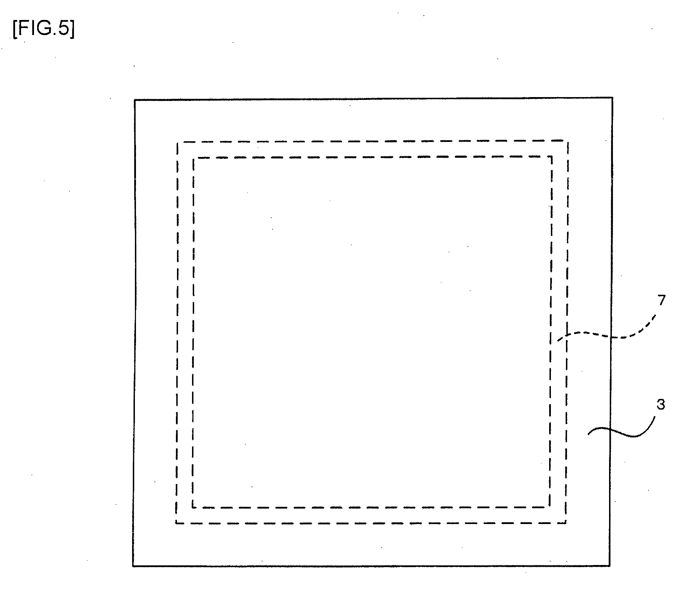

Figs. 1 - 5 are explanatory drawings of an embodiment of the present invention. Figs. 1 - 3 are schematic diagrams for explaining a conductive film formation step. Fig. 4 is a schematic cross-sectional view showing layered structure after the ultraviolet ray irradiation. Fig. 5 is a plan view of a conductive film pattern.

In the figures, the reference character "1" represents a conductive layer (transparent conductive layer: carbon nanotube layer) formed of carbon nanotubes.

Single-wall carbon nanotubes, double-wall carbon nanotubes, multiple-wall carbon nanotubes, etc. can be taken as examples of the carbon nanotubes (CNTs) forming the conductive layer 1. Above all, single-wall carbon nanotubes are the most preferable. Single-wall carbon nanotubes whose G/D is 10 or higher (e.g., 20 - 60) are particularly preferable. Further, CNTs having diameters of 0.3 - 100 nm are preferable. CNTs having diameters of 0.3 - 2 nm are particularly preferable. CNTs having lengths of 0.1 - 100 µm are preferable. CNTs having lengths of 0.1 - 5 µm are particularly preferable. The CNTs in the conductive layer 1 are entangled with one another.

Single-wall carbon nanotubes obtained by any manufacturing method are usable. For example, single-wall carbon nanotubes obtained by manufacturing methods such as arc discharge, chemical vapor deposition, laser vaporization, etc. can be used. However, single-wall carbon nanotubes obtained by arc discharge are preferable from the viewpoint of crystalline properties. Such single-wall carbon nanotubes obtained by arc discharge are also easy to acquire. The single-wall carbon nanotubes are desired to be those that have undergone acid treatment. The acid treatment is performed by immersing the single-wall carbon nanotubes in acidic liquid. Besides the immersion, other methods like spraying may also be employed. Various types of acidic liquids can be used. For example, either inorganic acid or organic acid is usable. However, inorganic acid is preferable. For example, nitric acid, hydrochloric acid, sulfuric acid, phosphoric acid, and various mixtures of these acids are usable. Above all, acid treatment by use of nitric acid or mixed acid of nitric acid and sulfuric acid is preferable. By the acid treatment, in cases where single-wall carbon nanotubes and carbon fine particles are physically coupled via amorphous carbon, the single-wall carbon nanotubes and the carbon fine particles are separated from each other through decomposition of the amorphous carbon, or fine particles of a metallic catalyst used for the production of the single-wall carbon nanotubes are decomposed. Functional groups adhered to the carbon nanotubes during the acid treatment in some cases. The conductivity was improved by the acid treatment. The single-wall carbon nanotubes are desired to be those whose purity has been increased by removal of impurities by means of filtration. It is because deterioration in the conductivity and in the optical transmittance caused by impurities can be prevented. Various types of techniques can be employed for the filtration. For example, suction filtration, pressure filtration, cross-flow filtration, etc. can be employed. Above all, employment of cross-flow filtration by use of hollow-fiber membrane is preferable from the viewpoint of scaling up.

Preferably, the conductive layer (carbon nanotube layer) 1 contains not only the aforementioned CNTs but also fullerenes. Thus, the conductive layer 1 is desired to contain CNTs having the above-described features and fullerenes. In this specification, the "fullerenes" can include "fullerene analogs". Fullerenes are desired to be used because the heat resistance was improved by the addition of fullerenes (conductivity was also excellent). Any type of fullerenes may be used. For example, C60, C70, C76, C78, C82, C84, C90, C96, etc. are usable. Of course, a mixture of multiple types of fullerenes may also be used. C60 is particularly preferable from the viewpoint of dispersion performance. Further, C60 is easy to acquire. Not only pure C60 but also mixtures of C60 and other types of fullerenes (e.g., C70) are also preferable. Fullerenes containing metallic atoms inside the fullerene molecules are also usable. As the fullerene analogs, those containing functional groups (OH groups, epoxy groups, ester groups, amide groups, sulfonyl groups, ether groups, etc.) are usable. Fullerene analogs containing phenyl-C61-propyl acid alkyl ester or phenyl-C61-butyric acid alkyl ester are also usable. Further, hydrogenated fullerenes and the like are also usable. Above all, fullerenes having OH (hydroxyl) groups (hydroxylated fullerenes) are preferable. It is because the dispersibility in the process of applying the single-wall carbon nanotube dispersion liquid was high. If a number of the OH group is few, the degree of improving the dispersibility of the single-wall carbon nanotubes drops. In contrast, the synthesis becomes difficult if a number of the OH group is too many. Therefore, a number of the OH group per fullerene molecule is preferably 5 - 30 groups (particularly preferably, 8 - 15 groups). If the amount of addition (content) of the fullerenes is too high, the conductivity drops. In contrast, achieved effects are weak if the fullerene content is too low. Therefore, the amount of the fullerenes is preferably 10 - 1000 pts. mass (particularly preferably 20 - 100 pts. mass) relative to 100 pts. mass of CNTs.

The conductive layer (carbon nanotube layer) 1 may contain binder resin. However, not containing binder resin is preferable from the viewpoint of conductivity. The binder resin is dispensable when CNTs in entangled structure are used, for example. In such structure, CNT molecules directly contact each other. With no insulating materials existing between CNT molecules, the conductivity of the conductive layer 1 becomes high. Incidentally, whether the CNTs are in entangled structure or not can be checked/judged by observing the surface of the conductive layer by use of a scanning electron microscope.

The conductive layer 1 is formed by applying a dispersion liquid, in which CNTs having the above-described features and fullerenes added as needed have been dispersed, on a substrate 2. Employable application methods include, for example, die coating, knife coating, spray coating, spin coating, slit coating, microgravure coating, flexography, etc. Of course, other methods may also be employed. The carbon nanotube dispersion liquid is applied on the entire surface of the substrate 2. For uniform progress of the insulation at the time of the ultraviolet ray irradiation, the conductive layer (carbon nanotube layer) 1 is desired to be formed uniformly.

Various types of materials may be used properly for the formation of the substrate 2. For example, resins such as polystyrene (PS), polymethyl methacrylate (PMMA), styrene-methyl methacrylate copolymer (MS), polycarbonate (PC), cycloolefin polymer (COP), cycloolefin copolymer (COC), polyethylene terephthalate (PET) and polyethylene naphthalate (PEN) are usable. In the present invention, the degree of request for heat resistance is low since heating is unnecessary for the formation of the conductive pattern. Therefore, even when resin is used as a material for forming the substrate 2, the degree of freedom of resin selection is high in the present invention. Besides resins, inorganic glass materials and ceramic materials are usable.

In the present invention, an overcoat layer (protective layer) 3 is formed on the conductive layer 1. The overcoat layer 3 is formed of organic or inorganic polymeric material, organic-inorganic hybrid resin, etc. Examples of the organic polymeric material include thermoplastic resin, thermosetting resin, cellulosic resin, photosetting resin, etc. Appropriate material is selected in consideration of factors such as visible light permeability, heat resistance of the substrate, glass transition point and film cure degree. Examples of the thermoplastic resin include, for example, polymethyl methacrylate, polystyrene, polyethylene terephthalate, polycarbonate, polylactic acid, ABS resin, etc. Examples of the thermosetting resin include, for example, phenol resin, melamine resin, alkyd resin, polyimide, epoxy resin, fluororesin, urethane resin, etc. Examples of the cellulosic resin include acetyl cellulose and triacetyl cellulose, for example. Examples of the photosetting resin include, for example, various types of oligomers, monomers, resins containing a photopolymerization initiator, etc. Examples of the inorganic polymeric material include, for example, silica sol, alumina sol, zirconia sol, titania sol, etc. A polymer obtained by causing hydrolysis and dehydration condensation to the aforementioned inorganic material by adding water and an acid catalyst is also usable as the inorganic polymeric material. Examples of the organic-inorganic hybrid resin include, for example, resins obtained by modifying part of the aforementioned inorganic material with organic functional groups, resins containing any one of various types of coupling agents (e.g., silane coupling agent) as the main ingredient, etc. If the film thickness of the overcoat layer 3 is too thick, the contact resistance of the conductive layer becomes high. In contrast, the effect as the protective film is hardly achieved if the film thickness of the overcoat layer 3 is too thin. Therefore, the thickness of the overcoat layer 3 is preferably 1 nm - 1 µm (particular preferably 10 nm or more, particular preferably 100 nm or less).

The overcoat layer 3 (formed on the conductive layer 1) in the present invention is made of a composition containing a hydrolysate of hydrolyzable organosilane, for example. Preferably, the overcoat layer 3 is made of a composition containing tetrafunctional hydrolyzable organosilane. Particularly preferably, the overcoat layer 3 is made of a composition containing a hydrolysate of tetrafunctional hydrolyzable organosilane and hydrolyzable organosilane having an epoxy group and an alkoxy group. Above all, such a composition in which the content of the hydrolysate of hydrolyzable organosilane having an epoxy group and an alkoxy group is 1 - 10 wt% relative to the total solid content of the resin is preferable. If a cohydrolysate of hydrolyzable organosilane having an epoxy group and an alkoxy group is contained in the composition, when the composition is applied and hardened, the epoxy groups of the cohydrolysate couple with oxygen sites (hydroxyl group, carbonyl group, etc.) contained in the substrate, by which the adhesion between the overcoat layer (protective layer) and the substrate is enhanced. The overcoat layer 3 may also be made of a composition containing silica-based metal oxide fine particles. Depending on the situation, the overcoat layer 3 may be made of a composition further containing a hydrolysate of hydrolyzable organosilane having a fluorine-substituted alkyl group. The hydrolysate of hydrolyzable organosilane is desired to be a hydrolysate obtained by a reaction in which the ratio of water to the alkoxy groups contained in the hydrolyzable organosilane is 1.0 - 3.0. The hydrolysate of hydrolyzable organosilane is desired to be a compound whose weight-average molecular weight in terms of polystyrene is 1000 - 2000.

The aforementioned tetrafunctional hydrolyzable organosilane is a compound represented as SiX₄, for example. The symbol "X" represents a hydrolyzable group. The hydrolyzable group can be, for example, an alkoxy group, an acetoxy group, an oxime group, an enoxy group, etc. In particular, tetrafunctional hydrolyzable organoalkoxysilane represented as Si(OR¹)₄ is preferable as the hydrolyzable group. Preferably, the symbol "R¹" represents a monovalent hydrocarbon group. For example, R¹ can be a monovalent hydrocarbon group whose carbon number is 1 - 8 (1-8C monovalent hydrocarbon group). Alkyl groups such as a methyl group, an ethyl group, a propyl group, a butyl group, a pentyl group, a hexyl group, a heptyl group and an octyl group are usable, for example. The tetrafunctional hydrolyzable organosilane used in this embodiment can be, for example, tetramethoxysilane, tetraethoxysilane, or the like. The hydrolyzable organosilane having an epoxy group and an alkoxy group is a compound represented as R²Si(OR³)₃ or R²R⁴Si(OR³)₂, for example. The symbol "R²" represents a group selected from an epoxy group, a glycidoxy group and their substitution products. The symbol "R³" represents a monovalent hydrocarbon group similarly to the aforementioned "R¹". The monovalent hydrocarbon group R³ can be a methyl group, an ethyl group, a propyl group, a butyl group or a pentyl group, for example. The symbol "R⁴" represents a group selected from hydrogen, an alkyl group, a fluoroalkyl group, an aryl group, an alkenyl group, a methacryloxy group, an epoxy group, a glycidoxy group, an amino group and their substitution products. The hydrolyzable organosilane having an epoxy group and an alkoxy group that is used in this embodiment can be, for example, γ-glycidoxypropyltrimethoxysilane, γ-glycidoxypropylmethyldiethoxysilane, γ-glycidoxypropyltriethoxysilane, γ-glycidoxypropyldimethoxymethylsilane, or the like. As the aforementioned silica-based metal oxide fine particles, hollow silica fine particles are preferably used. The hollow silica fine particle is a silica-based metal oxide having a hollow part formed inside its shell. The shell is desired to be made of porous material having pores. Even hollow silica fine particles with the pores occluded and the hollow parts sealed up are also usable. Incidentally, the material of the silica-based metal oxide fine particles is not necessarily restricted to the above-explained hollow silica as long as the material contributes to the reduction in the refractive index of the formed coating.

With such a composition of the overcoat layer, the optical reflectance becomes low and the optical transmittance becomes high. Further, physical protection against friction and the like is strong. Protection is strong also against environmental variations such as heat and humidity. With such an overcoat layer 3, denaturation of conductive carbon nanotubes into insulating carbon nanotubes achieved by short-time ultraviolet ray irradiation has been observed although the cause of the speedup has not been clarified so far. Therefore, it is preferable in the present invention that such an overcoat layer be formed prior to the ultraviolet ray irradiation step.

The overcoat layer 3 is formed by application of a coating material containing the above composition. As the application method for the coating material, the method described in the explanation of the application of the CNT dispersion liquid can be employed. The application is performed on the conductive layer (carbon nanotube layer), and that on the entire surface. For the uniform progress of the insulation at the time of the ultraviolet ray irradiation, the overcoat layer 3 is also desired to be formed uniformly.

The reference character "4" represents a photomask. The photomask 4 is formed of material not transmitting (allowing through) ultraviolet rays, for example. In particular, the photomask 4 is formed of material not transmitting the ultraviolet rays having the wavelength used for the insulation. For example, the photomask 4 can be formed of metal such as gold, silver, copper, aluminum or stainless steel. Of course, the material of the photomask 4 is not restricted to those materials. Depending on the situation, there can be restrictions on the patternable pattern and the resolution. Openings (ultraviolet ray transmitting parts) are formed corresponding to the areas to be irradiated with the ultraviolet rays (areas other than those of the conductive film(s): areas that should be insulated). While the photomask 4 is formed of material not transmitting the ultraviolet rays in the above explanation, it is also possible to form the photomask 4 with material transmitting the ultraviolet rays and then form a film not transmitting the ultraviolet rays on the surface of the photomask 4. In this case, quartz glass can be used as the base material of the photomask 4. Thus, it is possible to form films of material not transmitting the ultraviolet rays (Au, Ag, Cu, Al, Cr, etc.) on the surfaces of particular parts (parts (areas) not to transmit the ultraviolet rays) of the quartz glass-made base material, for example. The photomask 4 is arranged on the overcoat layer 3. Therefore, when the ultraviolet rays are applied from above to the photomask 4 arranged on the overcoat layer 3, the conductive layer (transparent conductive layer: carbon nanotube layer) 1 is irradiated with the ultraviolet rays that have passed through the photomask 4 via the aforementioned openings (ultraviolet ray transmitting parts).

In the present invention, ultraviolet rays are applied to the carbon nanotube layer (conductive layer: transparent conductive layer) 1. The wavelength of the ultraviolet rays is preferably 10 - 400 nm, more preferably 150 - 260 nm, particularly preferably 150 - 180 nm, and the most preferably 160 - 175 nm. For example, when long-wavelength ultraviolet rays over 400 nm were applied, the denaturation from conductive carbon nanotubes into insulating carbon nanotubes hardly occurred. In this connection, the denaturation was hardly caused by irradiation with ultraviolet rays emitted from a high-pressure mercury vapor lamp used for ordinary photolithography processes (wavelength: 365 nm). In order to cause the denaturation from conductive carbon nanotubes into insulating carbon nanotubes, the wavelength of the ultraviolet rays used for the irradiation was more preferably 260 nm or less (still more preferably 180 nm or less). For example, by the irradiation with ultraviolet rays emitted from a low-pressure mercury vapor lamp (wavelength: 185 nm, 254 nm), carbon nanotubes turned from conductive into insulating with ease in the irradiated parts. However, a phenomenon like discoloration was sometimes found in the substrate 2 in cases where the substrate 2 was made of resin. In consideration of these results, the wavelength of the ultraviolet rays used for the irradiation was particularly preferably 180 nm or less (the most preferably 175 nm or less). For example, ultraviolet rays from a xenon excimer lamp (wavelength: 172 nm) were especially preferable. The time (time length) of the irradiation with the ultraviolet rays having the above properties is approximately 10 seconds - 1 hour, for example (preferably 1 minute or more, more preferably 10 minutes or more, preferably 40 minutes or less, more preferably 30 minutes or less). The irradiation time varies to some extent depending on the thickness of the carbon nanotube layer. The irradiation time also varies depending on the presence/absence of the overcoat layer. The irradiation time also varies to some extent depending on the type and the thickness of the overcoat layer.

In the present invention in which the conductive carbon nanotube layer is turned into a prescribed conductive (or insulating) pattern by means of ultraviolet ray irradiation, the carbon nanotubes are not removed (differently from the conventional pattern formation techniques), that is, carbon nanotubes exist also in the parts as the insulating pattern. Thus, the problems with the patterning performed by the removal of carbon nanotubes are drastically mitigated/eliminated in the present invention. Further, visualization of the pattern is difficult since carbon nanotubes exist both in the insulating parts and in the conductive parts. Furthermore, the resolution of the formed pattern is high since the pattern formation method employs ultraviolet ray irradiation.

In the following, this embodiment will be explained in more detail by taking some concrete examples. However, it should be understood that the present invention is not to be restricted to the particular illustrative examples described below.

### [Example 1]

Acid treatment, water wash (aqueous cleaning), centrifugation and filtration were performed on single-wall carbon nanotubes synthesized by means of arc discharge (available on the market). A 0.2 wt% aqueous solution of a surface-active agent TritonX-100 (produced by GE Healthcare) was added to the carbon nanotubes obtained by the above refining. A dispersion process using ultrasonic waves was performed on the carbon nanotube-containing aqueous solution. Subsequently, centrifugation was conducted. By the above procedure, a carbon nanotube dispersion liquid (CNT: 1000 ppm) was obtained.

Application of the above carbon nanotube dispersion liquid was carried out. The application method was die coating. The thickness of the application (coating) was 0.05 µm after the drying (see Fig. 1). A PET film A4100 (produced by Toyobo Co., Ltd.) was used as the substrate 2. After the application, the methanol wash was conducted in order to remove the surface-active agent contained in the coating (carbon nanotube layer) 1. Thereafter, the drying (1 minute; 100 °C) was conducted.

The overcoat layer 3 was formed on the above carbon nanotube layer (coating) 1 (see Fig. 2). For the formation of the overcoat layer 3, 3.8 wt% Aerosera (composition containing hydrolyzable organosilane: produced by Panasonic Electric Works Co., Ltd.) was used. The application method was die coating. The thickness of the application (coating) was 0.1 µm after the drying.

Thereafter, the photomask 4 made of quartz glass was arranged on the above overcoat layer 3. The photomask 4 was a mask provided with an ultraviolet ray transmitting part. Specifically, parts of the photomask 4 other than the ultraviolet ray transmitting part were provided with Cr plating 5. The part (ultraviolet ray transmitting part) 6 not provided with the Cr plating 5 was in the shape of a 5 mm square with a line width of 100 µm.

Then, the above structure was irradiated with ultraviolet rays of a xenon excimer lamp (wavelength: 172 nm) applied from above the photomask (see Fig. 3). The irradiation time was 20 minutes.

The conduction (continuity) between the inside and the outside of the pattern (square) was checked by use of a tester. As a result, it was found that there was no conduction between the inside and the outside of the pattern (insulation). In Figs. 4 and 5, the reference character "7" represents the part where the conductive carbon nanotube layer was denatured into an insulating carbon nanotube layer by the ultraviolet ray irradiation.

Further, the pattern (square) of the photomask and the pattern (square) formed in the carbon nanotube conductive layer were compared with each other. The precision of the pattern formation in the carbon nanotube conductive layer was high.

### [Example 2]

The experiment was conducted substantially in the same way as the example 1 except that the overcoat layer 3 was not formed in this example. Incidentally, the ultraviolet ray irradiation time in this example was 40 minutes.

In this example, except for the longer ultraviolet ray irradiation time, a pattern equivalent to that of the example 1 was formed. In view of this result, the formation of the overcoat layer was found to be preferable.

### [REFERENCE CHARACTER LIST]

- 1: conductive layer (carbon nanotube layer)
- 2: substrate
- 3: overcoat layer (protective layer)
- 4: photomask
- 5: Cr plating
- 6: ultraviolet ray transmitting part
- 7: insulating carbon nanotube layer

## Claims

1. A conductive film formation method for forming a conductive film in a prescribed pattern, comprising:
a step in which a conductive carbon nanotube layer is formed; and
an ultraviolet ray irradiation step in which areas of the conductive carbon nanotube layer formed in the above step, other than parts corresponding to the prescribed pattern, are irradiated with ultraviolet rays, wherein:
conductive carbon nanotubes in the ultraviolet ray irradiation areas turn insulating, and
conductive carbon nanotubes in ultraviolet ray non-irradiation areas retain their conductive property.

2. The conductive film formation method for forming a conductive film in a prescribed pattern according to claim 1, further comprising a step in which an overcoat layer is formed on the surface of the conductive carbon nanotube layer before the ultraviolet ray irradiation step.

3. The conductive film formation method for forming a conductive film in a prescribed pattern according to claim 2, wherein the overcoat layer contains a hydrolysate of hydrolyzable organosilane.

4. The conductive film formation method for forming a conductive film in a prescribed pattern according to claim 1 or 2, wherein the conductive carbon nanotubes are single-wall carbon nanotubes that have undergone acid treatment.

5. The conductive film formation method for forming a conductive film in a prescribed pattern according to any one of claims 1 - 4, wherein the ultraviolet ray irradiation step is a step in which the ultraviolet ray irradiation is performed via a mask having a function of blocking the ultraviolet rays in the parts corresponding to the prescribed pattern.

6. The conductive film formation method for forming a conductive film in a prescribed pattern according to any one of claims 1 - 5, wherein the ultraviolet ray irradiation step is a step in which ultraviolet rays whose wavelength is in a range of 150 - 180 nm are used for the irradiation.

7. The conductive film formation method for forming a conductive film in a prescribed pattern according to any one of claims 1 - 6, wherein the ultraviolet ray irradiation step is a step in which ultraviolet rays whose wavelength is in a range of 150 - 260 nm are used for the irradiation.

8. The conductive film formation method for forming a conductive film in a prescribed pattern according to any one of claims 1 - 6, wherein the ultraviolet ray irradiation step is a step in which ultraviolet rays whose wavelength is in a range of 10 - 400 nm are used for the irradiation.

9. A conductive film which is formed by the conductive film formation method for forming a conductive film in a prescribed pattern according to any one of claims 1 - 8.

10. A conductive carbon nanotube insulation method for denaturing conductive carbon nanotubes into insulating carbon nanotubes, comprising an ultraviolet ray irradiation step in which the conductive carbon nanotubes are irradiated with ultraviolet rays.

11. The conductive carbon nanotube insulation method according to claim 10, wherein the ultraviolet ray irradiation step is a step in which ultraviolet rays whose wavelength is in a range of 10 - 400 nm are used for the irradiation.

12. The conductive carbon nanotube insulation method according to claim 10, wherein the ultraviolet ray irradiation step is a step in which ultraviolet rays whose wavelength is in a range of 150 - 260 nm are used for the irradiation.

13. The conductive carbon nanotube insulation method according to claim 10, wherein the ultraviolet ray irradiation step is a step in which ultraviolet rays whose wavelength is in a range of 150 - 180 nm are used for the irradiation.

14. An insulation film which is formed by the conductive carbon nanotube insulation method according to any one of claims 10 - 13.
